# EUROPÄISCHE PATENTANMELDUNG

(11) **EP 2 109 159 A2**
(43) Veröffentlichungstag der Anmeldung: **14.10.2009**
(21) Anmeldenummer: 08075952.5
(22) Anmeldetag: 18.12.2008
(51) Int. Cl.: H01L 35/32

(54) **Thermoelektrisches Generatorsystem zur elektrischen Stromerzeugung und für Heizzwecke aus Sonnenenergie**

(30) Priorität: 21.12.2007 DE 102007062286
(71) Anmelder: Bleich, Karl-Heinz, Dr.-Ing., 14478 Potsdam (DE)
(72) Erfinder: Bleich, Karl-Heinz, Dr.-Ing., 14478 Potsdam (DE)

(57) **Zusammenfassung**

Inhalt der Erfindung ist ein neuartiges thermoelektrisches Generatorsystem, das als solare Kraft-Wärmekopplung wirkt. Der Wirkungsgrad der thermoelektrischen Generatoren ist thermodynamisch sowohl theoretisch begrenzt durch den Carnotprozeß als auch zusätzlich durch technische Wärmeverluste.

Im Patent wird eine erfinderische Lösung beschrieben zum Überwinden dieser physikalischen und technischen, vorwiegend materialbedingten, Grenze, um derzeit eine praktikable Ergänzung zur photovoltaischen Technologie zu bieten. Die photovoltaischen Module liefern ausschließlich bei Sonnenlicht elektrischen Strom. Um der physikalischen Tatsache zu genügen, muss lösungsgemäß die Solarstrahlung in Solarwärme umgewandelt und langzeitig gespeichert werden. Der derzeitige Nachteil der kleineren Effektivität der thermoelektrischen Halbleitermaterialien im Vergleich zu photovoltaischen Solarmodulen wird durch die ununterbrochene Betriebszeit rund um die Uhr und die bessere Ausnutzung der thermoelektrischen Generatorleistung mehr als ausgeglichen. Die Restwärmeenergie kann im Sinne einer solaren Kraft-Wärmekopplung für Heizzwecke verschiedener Art nutzbar gemacht werden.

Die zeitliche Konstanz der erzeugten Elektroenergie stellt einen weiteren großen Vorteil gegenüber den photovoltaischen Modulen dar.

## Beschreibung

### Stand der Technik

Thermoelektrische Generatoren werden bisher hauptsächlich in 3 Bereichen der Technik eingesetzt. In historischer Reihenfolge sind das die Energieversorgung bei Weltraumflügen außerhalb der nutzbaren Sonnenenergie-Sphäre, in neuerer Zeit in der Erzeugung von kleinsten elektrischen Leistungen, z. B. in moderner Kraftfahrzeugelektronik und drittens in biomedizinischen Geräten und ähnlichen Spezialanwendungen. In der Weltraumforschung benutzt man sie seit längerem in Isotopenbatterien oder vereinzelt auch in Kernfissionsreaktoren zur langzeitigen Bereitstellung der elektrischen Bordenergie bei Langzeitflügen. Das sind alles Sonderanwendungen bei meist relativ hohen Temperaturen mit teuren thermoelektrischen Materialien (TE-Materialien), bei denen der energetische Wirkungsgrad und die ökonomische Wirtschaftlichkeit keine große Rolle spielen.

Auch wurden wissenschaftliche Untersuchungen veröffentlicht, bei denen altbekannte TE-Materialien mit Solarstrahlung als Primärenergie für Generatorzwecke auf der Erde ausgemessen wurden. Die Wirkungsgrade erwiesen sich jedoch nicht als konkurrenzfähig für breite terrestrische Anwendungen im Vergleich mit photovoltaischen Modulen (PV-Modulen).

### Die erfinderische Idee/Lösung

Die Erfindung basiert auf den intensiv erforschten TE-Materialien Antimon- und Wismut-Telluriden, die preiswert herstellbar sind, weil sie massenweise für die bekannten Peltierelemente zur elektrischen Kühlung oder Heizung notwendig sind. Der Wirkungsgrad der thermoelektrischen Generatoren ist thermodynamisch sowohl theoretisch begrenzt durch den Carnotprozess als auch zusätzlich durch die technischen Verluste. Der Ausgleich dieser physikalischen und technischen Grenze ist die erfinderische Grundidee, um derzeit eine praktikable Ergänzung zur photovoltaischen (PV)-Technologie zu erhalten. Die Photovoltaik (PV) arbeitet ausschließlich bei direktem und/oder diffusem Sonnenlicht. Das ist eine natürliche Beschränkung der PV-Technologie. Diese physikalische Beschränkung kann die erfinderische Idee durch technologische Maßnahmen überwinden, weil Solarwärme vielfältig speicherbar ist, im Gegensatz zur Solarstrahlung, welche direkt physikalisch gar nicht speicherbar ist. Um der physikalischen Tatsache zu genügen, muss also die Solarstrahlung absorbiert und somit erstens zu Solarwärme umgewandelt werden und zweitens gespeichert werden. Die Speicherung der absorbierten Solarwärme führt zu einem ununterbrochenen Betrieb der thermoelektrischen Generatoren rund um die Uhr, und zwar so lange, wie es die Menge der gespeicherten thermischen Energie erlaubt. Große Wärmespeicher können lange Zeiten ungenügender Solareinstrahlung überbrücken.

Der derzeitige Nachteil des kleineren energetischen Wirkungsgrades, verursacht vorwiegend durch die schlechte Effektivität Z der TE-Materialien, wird durch die wesentlich längere Betriebszeit und bessere Ausnutzung der TE-Generatorleistung mehr als ausgeglichen.

Die erzeugte Elektroenergie unterliegt nicht den naturgemäß großen Schwankungen im Vergleich zur Photovoltaik oder Windenergienutzung. Bei Elektroenergie-Einspeisung in das öffentliche Netz stellt die zeitliche Konstanz für die Netzbetreiber einen großen Vorteil dar.

### Ausführungsbeispiele

a) Thermische Flachkollektoren oder besser Vakuumröhren-Kollektoren absorbieren die zeitlich unregelmäßige Solarstrahlung. Wärmeisolierte wassergefüllte Stahlbehälter speichern im Megawatt-Stunden-Bereich die thermische Energie über längere Zeit verlustarm. Mittels Wärmetauschern werden die beiden Seiten der TE-Module heiß und kalt beaufschlagt. Durch inversen Betrieb der in Massenproduktion preiswert hergestellten Peltiermodule kann eine geschickte Nutzung für den Generatorbetrieb praktiziert werden. Das bedeutet, dass mittels Seebeck-Effektes die benötigte thermoelektrische Gleichspannung erzeugt wird. Die Elektroenergie kann über die bekannte Wechselrichter-Technik der PV ins öffentliche Stromnetz, wie schon lange Stand der Technik, eingespeist werden. Die Niedrigtemperatur-Wärmeenergie wird üblicherweise wie in der Solarthermie für Heizzwecke ausgenutzt. Damit ist ein hoher Gesamtwirkungsgrad der Kraft-Wärmekopplung erzielbar.
b) Die Solarenergie wird aus Latent-Wärme-Speichern mit höherer Energiedichte und verlustärmer als aus Wasserspeichern für die thermoelektrischen Generatoren und für Heizzwecke bereitgestellt.
c) Erfindungsgemäß ist eine zusätzliche Benutzung von Kältespeichern zur Erhöhung der den Carnot-Wirkungsgrad bestimmenden Temperaturdifferenz zwischen heißer und kalter Seite der TE-Generatoren. Beispiel: Bei üblichen Antimon- und Wismut-Telluriden kann eine maximale Temperaturdifferenz von ca. 300 Kelvin angewendet werden.
d) Mittels Anlegen von speziell orientierten Magnetfeldern an die thermoelektrischen Schenkelpaare kann in bestimmten Arbeitstemperaturbereichen die Effektivität Z x T gesteigert werden. Die Effekte sind in der physikalischen Literatur bekannt, aber ingenieurtechnisch kaum beachtet. Eigene erste Laboruntersuchungen mit starken Neodymmagneten oder fremd- und selbsterregten Elektromagneten zeigten mögliche Verbesserungen der thermoelektrischen Energieumwandlung und damit eine Potenzialsteigerung für den Einsatz von thermoelektrischen Generatoren in der regenerativen Energiegewinnung der Zukunft.

## Patentansprüche

1. das Zusammenwirken von Solarstrahlungsabsorbern der Solarthermie, thermischen Energiespeichern und Halbleiter-Thermoelementmodulen

2. vorzugsweise Strahlungsabsorbern im Hochtemperaturbereich, zum Beispiel Vakuumröhrenkollektoren oder Solarstrahlungs-Konzentratoren wie Parabolrinnen oder Parabolspiegeln

3. thermische Energiespeicher, insbesondere Heißwasserspeicher, Thermoölspeicher, Latentwärmespeicher verschiedener Art und Kältespeicher

4. Einsatz von preiswerten erprobten thermoelektrischen Materialien, wie z. B. Antimon- und Wismut-Telluriden in Peltiermodulen mit optimaler Z x T-Ausnutzung des effektiven Temperaturbereiches, d.h. einschließlich des nutzbaren Kältebereiches.

5. optimierte Anpassung der Speicherkapazität und der thermischen Energiespeicherart an die Generatorleistung in Abhängigkeit von der durchschnittlichen solaren Einstrahlung am geographischen Nutzungsort.

6. Die Maximierung des energetischen Wirkungsgrades durch zusätzliche Nutzung von solarer Kälteerzeugung und Kältespeicherung nach Abwägung von Nutzen und Aufwand zur Realisierung einer optimalen Kühlung der kalten Generatorseite.

7. Das Anlegen eines longitudinalen oder transversalen Magnetfeldes bezüglich des Temperaturgefälles im Halbleiter-Thermoelement zur Erhöhung der Effizienz des Seebeck-Effektes im thermoelektrischen Generator.

8. durch die Gebrauchseigenschaften einer energetisch vorteilhaften Kraft-Wärmekopplung, weil die Wärmeenergie nach Bedarf für Raumheizung oder Warmwasser-Bereitstellung mit einem günstigen Gesamtwirkungsgrad genutzt wird.

9. die Nutzung der gespeicherten Kälte zur Kühlung und Klimatisierung
